# EUROPÄISCHE PATENTSCHRIFT

(11) **EP 3 312 571 B1**
(45) Veröffentlichungstag und Bekanntmachung des Hinweises auf die Patenterteilung: **13.10.2021**
(21) Anmeldenummer: 16194910.2
(22) Anmeldetag: 20.10.2016
(51) Int. Cl.: G01F 23/26, G01F 23/00, G01F 25/00, G01N 27/22, G01R 27/26

(54) **IMPEDANZGRENZSCHALTER MIT ZUSÄTZLICHER SCHIRMELEKTRODE**
IMPEDANCE TYPE MEDIUM LIMIT SWITCH COMPRISING AN ADDITIONAL SHIELD ELECTRODE
INTERRUPTEUR À IMPÉDANCE DE NIVEAU DE LIQUIDE COMPRENANT UNE ÉLECTRODE DE PROTECTION SUPPLÉMENTAIRE

(43) Veröffentlichungstag der Anmeldung: 25.04.2018
(73) Patentinhaber: VEGA Grieshaber KG, 77709 Wolfach (DE)
(72) Erfinder: WEINZIERLE, Christian, 77709 Wolfach (DE); GRIEßBAUM, Karl, 77796 Mühlenbach (DE); WÄLDE, Steffen, 78078 Niedereschach (DE)
(74) Vertreter: Maiwald Patent- und Rechtsanwaltsgesellschaft mbH

(56) Entgegenhaltungen:
- EP-A1- 3 078 943
- DE-A1-102008 043 412
- DE-A1-102010 038 535
- US-A- 4 555 941

## Beschreibung

### Gebiet der Erfindung

Die Erfindung betrifft einen Impedanzgrenzschalter zum Erfassen eines Grenzstandes eines Mediums, eine Verwendung und ein Verfahren.

### Hintergrund

Die Bestimmung des Grenzstandes eines Füll- oder Schüttgutes ist erforderlich, wenn vordefinierte Füllhöhen erfasst werden sollen. Die Grenzstandbestimmung erfolgt beispielsweise in Prozesstanks, Lagertanks, Silos oder Rohrleitungen in der Prozessindustrie. Grenzschalter werden in unterschiedlichsten Flüssigkeiten sowie granulierten und pulverförmigen Schüttgütern eingesetzt. Je nach Eigenschaft des Füllguts sowie den individuellen Prozessbedingungen kommen unterschiedliche Grenzschalter zum Einsatz. Bekannt sind Impedanzgrenzschalter, TDR-Melder, Vibrationsgrenzschalter sowie Sensoren, die nach dem kapazitiven Messprinzip arbeiten. Ein vom Grenzschalter abgegebener Schaltbefehl startet oder stoppt Befülleinrichtungen, wie Förderbänder oder Pumpen.

EP 2 708 879 A1 beschreibt einen Impedanzgrenzschalter zur resonanten Impedanzmessung.

Verschmutzungen an der Messsonden können das Resonanzverhalten eines solchen Impedanzgrenzschalters sehr stark beeinflussen. Ein sicheres und zuverlässiges Schalten für unterschiedlichste Medien kann dann oft nur gewährleistet werden, wenn ein Abgleich erfolgt. In diesem Fall kann durch einen Einlernvorgang auf das zu messende Medium die Grenzstanddetektion weitgehend zuverlässig realisiert werden.

US 4,555,941 A1 beschreibt ein Füllstandmessgerät zur Anzeige des Füllstands eines Materials in einem Behälter als eine Funktion der Materialkapazität.

EP 3 078 943 A1 beschreibt einen abgleichfreien Grenzstandsensor mit einer Sensoreinheit, die ausgeführt ist, mindestens zwei Messungen in zwei voneinander verschiedenen Eindringtiefen im Medium durchzuführen.

DE 10 2008 043 412 A1 beschreibt eine Vorrichtung zur Bestimmung und Überwachung einer Prozessgröße eines Mediums mit einer Auswerteeinheit, die das Überschreiten und Unterschreiten eines vorgebbaren Grenzwertes der Prozessgröße durch das Medium überwacht.

DE 10 2010 038 535 A1 beschreibt eine Vorrichtung zur Bestimmung und Überwachung eines vorgegebenen Füllstands eines Mediums in einem Behälter, umfassend eine kapazitive oder konduktive Sondeneinheit mit mindestens einer Elektrode.

### Zusammenfassung der Erfindung

Es ist eine Aufgabe der Erfindung, die Wahrscheinlichkeit eines Messfehlers aufgrund von Anhaftungen an der Messsonde zu verringern.

Diese Aufgabe wird durch die Merkmale der unabhängigen Patentansprüche gelöst. Weiterbildungen der Erfindung ergeben sich aus den Unteransprüchen und der folgenden Beschreibung.

Die Erfindung betrifft einen Impedanzgrenzschalter zum Erfassen eines Grenzstandes eines Mediums, beispielsweise einer Flüssigkeit oder eines granularen oder pulverförmigen Schüttguts. Der Impedanzgrenzschalter weist eine Elektronikeinheit, eine Messelektrode, eine Bezugselektrode und eine dazwischen angeordnete Schirmelektrode sowie eine Trenneinheit auf. Zwischen Messelektrode und Bezugselektrode ergibt sich eine Messkapazität, welche zusammen mit einer Induktivität einen Schwingkreis ausbildet. Die Elektronikeinheit dient der Erzeugung eines elektrischen Anregungssignals,welches an den Schwingkreis angelegt wird und den gesamten Schwingkreis speist.

Die Resonanzstelle des Schwingkreises wird von der Elektronikeinheit sowohl hinsichtlich der Amplitude, als auch der Frequenz bestimmt.

An die Schirmelektrode, die zwischen der Messelektrode und der Bezugselektrode beabstandet von diesen angeordnet ist, wird über die Trenneinheit das Schwingkreissignal, das in der Leitung zwischen der Induktivität und der Messlelektrode entsteht, angelegt. Dieses Signal geht auf das Anregungssignal zurück, das den Schwingkreis zu Schwingungen anregt. Die Trenneinheit, welche zwischen die Messelektrode und die Schirmelektrode geschaltet ist, sorgt dafür, dass die Messelektrode von der Schirmelektrode entkoppelt ist. Auf diese Weise wird gewährleistet, dass sich der Schwingkreis nur zwischen der Messkapazität und der Induktivität ausbilden kann und nicht zwischen beispielsweise der Kombination aus Mess- und Schirmkapazität und der Induktivität.

Die Schirmelektrode ist ausgeführt, die elektrischen Feldlinien, die sich zwischen der Messelektrode und der Bezugselektrode ausbilden, möglichst tief in das Medium hineinzutreiben, sodass der Weg, den die Feldlinien durch eventuell am Sensor des Impedanzgrenzschalters auftretende Anhaftungen durchlaufen, möglichst kurz ist. Dies wird dadurch erreicht, dass das elektrische Feld tiefer in das Medium hineinläuft und somit "steiler" durch die Anhaftung läuft, als es der Fall wäre, wenn keine Schirmelektrode vorgesehen wäre.

Gemäß einer Ausführungsform ist die Trenneinheit ausgeführt, dafür zu sorgen, dass die Messelektrode und die Schirmelektrode mit dem gleichen Signal, dem Schwingkreissignal, gespeist werden. Insbesondere ist es vorteilhaft, wenn die Amplitude und die Phasen dieses Wechselspannungssignals an Messelektrode und Schirmelektrode übereinstimmen. Dadurch wird eine maximale Schirmwirkung erzielt.

Gemäß einer weiteren Ausführungsform der Erfindung weist der Impedanzgrenzschalter eine stiftförmige Messsonde auf, in welcher die Messelektrode, die Schirmelektrode, die Bezugselektrode und/oder die Trenneinheit angeordnet sind. Grundsätzlich ist es auch möglich, dass ein oder mehrere der Elektroden auf der Oberfläche der Messsonde angeordnet sind oder einen Teil des Messsondengehäuses ausbilden.

Gemäß einer weiteren Ausführungsform der Erfindung weist der Kopfbereich der Messsonde eine Isolationsumhüllung auf, welche die Messelektrode und/oder die Schirmelektrode vom zu vermessenden Medium isoliert. Messelektrode und/oder Schirmelektrode befinden sich in dieser Ausführungsform im Inneren der Messsonde. Isolation bedeutet in diesem Zusammenhang insbesondere eine elektrische, galvanische Isolation.

Gemäß einer weiteren Ausführungsform der Erfindung liegt die Schirmelektrode an der Innenwandung der Isolationsumhüllung an. Beispielsweise ist sie flächig ausgeführt und folgt dem Oberflächenverlauf der Isolationsumhüllung.

Gemäß einer weiteren Ausführungsform ist die Schirmelektrode ringförmig ausgebildet, weist also ein Loch in ihrer Mitte auf, durch welches in einer weiteren Ausführungsform die Messelektrode hindurchgeführt ist. Die Messelektrode kann beispielsweise pilzförmig ausgeführt sein, wobei der Kopf des Pilzes in der Spitze der Messsonde angeordnet ist.

Gemäß einer weiteren Ausführungsform der Erfindung sind Messelektrode, Schirmelektrode und Bezugselektrode konzentrisch zueinander angeordnet. Es kann sich neben einer stiftförmigen Messsonde auch um eine flächige Messsonde handeln, in welcher die Messelektrode, die Schirmelektrode und die Bezugselektrode konzentrisch zueinander und in derselben Ebene angeordnet sind.

Gemäß einer Ausführungsform der Erfindung weist die Trenneinheit eine Verstärkerschaltung auf, beispielsweise mit einer Verstärkung von 1.

Die Erfindung betrifft zudem die Verwendung eines oben und im Folgenden beschriebenen Impedanzgrenzschalters zum Erfassen des Grenzstandes eines Mediums.

Die Erfindung betrifft weiter ein Verfahren zum Erfassen des Grenzstandes eines Mediums mit einem Impedanzgrenzschalter, insbesondere einem oben und im Folgenden beschriebenen Impedanzgrenzschalter, bei dem zunächst ein Anregungssignal, bei dem es sich um ein Wechselspannungssignal handelt, erzeugt wird. Dieses Anregungssignal wird an den Schwingkreis angelegt. Dabei wird sowohl die Messelektrode als auch die Schirmelektrode amplitudengleich und phasengleich angeregt. Mess- und Schirmelektrode sind voneinander entkoppelt, sodass sich der Schwingkreis lediglich zwischen der Messkapazität und einer daran angeschlossenen Induktivität ausbilden kann. Das Resonanzverhalten des Schwingkreises wird untersucht, indem die Anregungsfrequenz durchgefahren wird und die Amplitude und die Frequenz der Schwingung des Schwingkreises im Resonanzpunkt bestimmt werden, um einen Grenzstand zu detektieren oder festzustellen, dass der Grenzstand noch nicht erreicht ist.

Auf diese Weise kann der Einfluss von Anhaftungen auf die resonante Impedanzmessung verringert werden und es ist möglich, auch ohne Abgleich eine sichere und zuverlässige Grenzstandbestimmung bereitzustellen. Zeitintensive Einlernphasen sind nicht notwendig und die Messsicherheit wird insgesamt erhöht. Das Prinzip der resonanten Impedanzmessung kann somit für einen universell einsetzbaren Grenzstandschalter verwendet werden, ohne dass es zu Messfehlern aufgrund des Einsatzes in verschiedenen Medien kommt.

Im Folgenden werden Ausführungsbeispiele der Erfindung beschrieben. Die Darstellungen in den Figuren sind schematisch und nicht maßstäblich. Werden in verschiedenen Figuren dieselben Bezugszeichen verwendet, so bezeichnen diese gleiche oder ähnliche Elemente.

### Kurze Beschreibung der Figuren

Fig. 1 zeigt einen Impedanzgrenzschalter.
Fig. 2 zeigt den Impedanzgrenzschalter der Fig. 1, wobei die Messsonde als Ersatzschaltbild dargestellt ist.
Fig. 3 zeigt einen Impedanzgrenzschalter gemäß einem Ausführungsbeispiel der Erfindung.
Fig. 4 zeigt den Impedanzgrenzschalter der Fig. 3, wobei die Messsonde als Prinzipschaltbild dargestellt ist.
Fig. 5 zeigt ein Trennelement gemäß einem Ausführungsbeispiel der Erfindung.
Fig. 6 zeigt ein Beispiel für Resonanzkurven des Impedanzgrenzschalters der Fig. 1.
Fig. 7 zeigt ein Auswertediagramm des Impedanzgrenzschalters der Fig. 1.
Fig. 8 zeigt ein Auswertediagramm für den Impedanzgrenzschalter der Fig. 3.
Fig. 9 zeigt einen Impedanzgrenzschalter gemäß einem weiteren Ausführungsbeispiel der Erfindung.
Fig. 10 zeigt einen Impedanzgrenzschalter gemäß einem weiteren Ausführungsbeispiel der Erfindung.
Fig. 11 zeigt ein Flussdiagramm eines Verfahrens gemäß einem Ausführungsbeispiel der Erfindung.

### Detaillierte Beschreibung von Ausführungsbeispielen

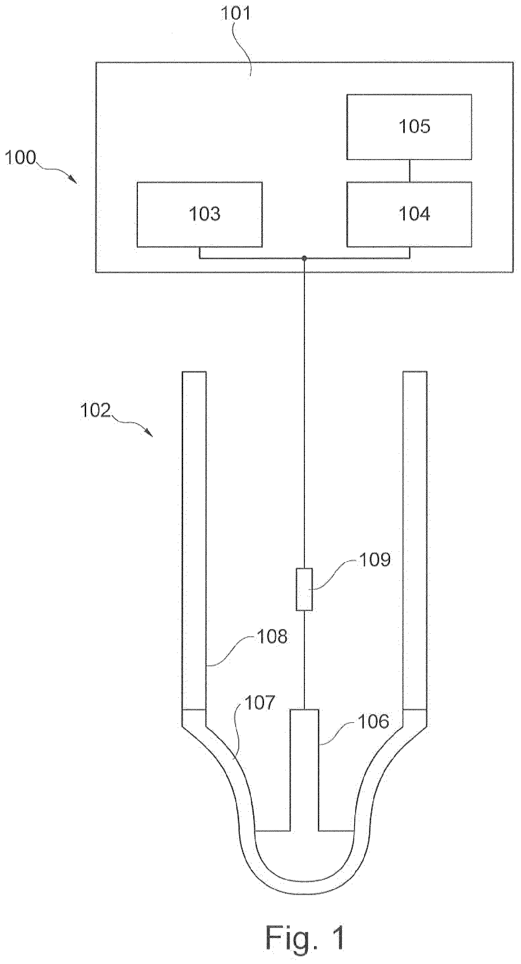

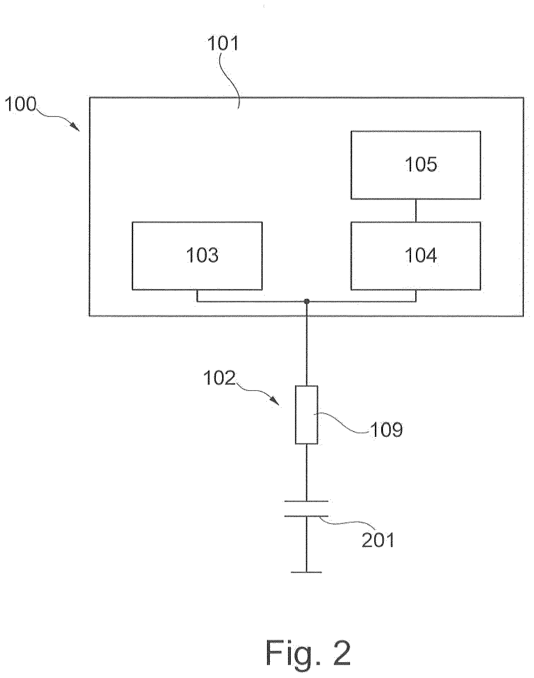

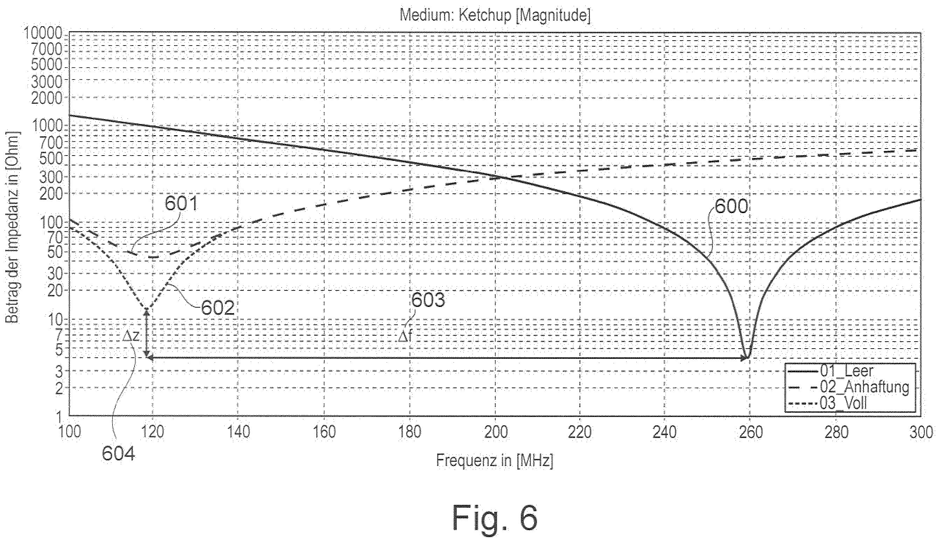

Fig. 1 zeigt einen Impedanzgrenzschalter 100 mit einer Elektronikeinheit 101 und einer Messsonde 102. Zwischen der Messelektrode 106 und der Bezugselektrode 108 bildet sich eine Messkapazität 201 aus (vgl. Fig. 2). Die Messkapazität 201 erzeugt mit einer diskreten Induktivität 109 eine Serienresonanz. Der Betrag der komplexen Impedanz dieses Schwingkreises wird beispielsweise im Bereich von 100 MHz und 300 MHz analysiert. Befindet sich ein Medium im Bereich der Messsonde 102, so ändert sich das Impedanzverhalten des Schwingkreises. Diese Änderung der Impedanz wird für die Auswertung herangezogen. Im Speziellen wird das Minimum der Resonanzkurve bezüglich einer Frequenzänderung 603 und einer Amplitudenänderung 604 (vgl. Fig. 6) ausgewertet und daraus ein Schaltbefehl generiert.

Eine Verschmutzung der Messsonde 102 kann das Resonanzverhalten sehr stark beeinflussen. Um dennoch ein präzises Messergebnis zu erzielen, bietet es sich an, einen Abgleich durchzuführen, Bei einem sogenannten Nassabgleich muss der Impedanzgrenzschalter in den Behälter eingebaut, sowie ein Befüllvorgang vorgenommen werden. Dabei wird der Behälter mit dem zu messenden Medium solange befüllt, bis die gesamte Messsonde mit dem Medium umgeben ist. Anschließend wird der Behälter wieder entleert. Nach dieser zeitintensiven Einlernphase ist das Resonanzverhalten für den Vollzustand bzw. Leerzustand bekannt und die Schaltschwellen können dementsprechend auf das Medium angepasst werden. Für jedes zu vermessende Medium muss ein solcher Vorgang durchgeführt werden, damit das Gerät sicher zwischen "Messsonde bedeckt" und "Messsonde nicht bedeckt" unterscheiden kann und eine Grenzstanddetektion sicher realisiert werden kann.

Sowohl die Signalerzeugung als auch die Signalaufbereitung und die Auswertung der Empfangssignale wird durch die Elektronikeinheit 101 vorgenommen. Zentrale Elemente der Elektronikeinheit sind die Signalerzeugungseinheit 103, die Signalaufbereitungseinheit 104 und die Auswerteeinheit 105.

Fig. 2 zeigt den Impedanzgrenzsehalter 100 der Fig. 1, wobei die Messsonde 102 als Ersatzschaltbild dargestellt ist. Die diskrete Induktivität 109 und die Messkapazität 201 bilden den resonanten Schwingkreis aus, welcher durch das Medium im Nahbereich der Messsonde verstimmt wird.

Der Schwingkreis wird durch die diskrete Induktivität 109 und die Messkapazität 201 gebildet. Die Messkapazität setzt sich aus der Messelektrode, der Bezugselektrode und der Isolierung zusammen. Dementsprechend wird auch die Bezugselektrode für den Schwingkreis benötigt.

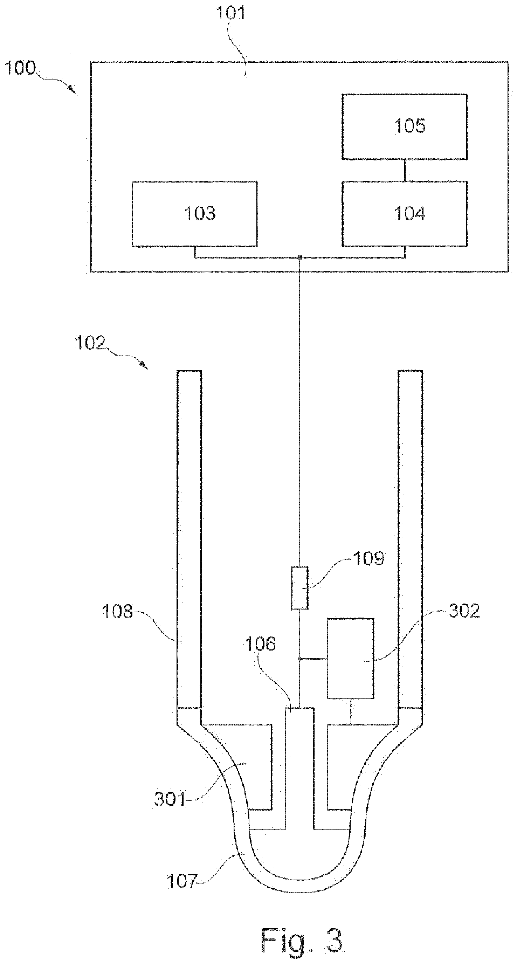

Fig. 3 zeigt einen Impedanzgrenzschalter 100 mit einer integrierten Schirmelektrode 301 und einer zusätzlichen Trenneinheit 302 gemäß einem Ausführungsbeispiel der Erfindung. Wird die Schirmelektrode 301 amplitudengleich und phasengleich wie die Messelektrode 106 angeregt, hat dies zur Folge, dass die elektrische Feldverteilung zwischen der Messelektrode 106 und der Bezugselektrode 108 tiefer in das Volumen des Mediums gedrängt wird. Der Impedanzgrenzschalter arbeitet somit volumensensitiver als der Impedanzgrenzschalter gemäß Fig. 1. Anhaftungen haben demzufolge einen geringeren Einfluss auf dessen Resonanzverhalten.

Zwischen der Messelektrode 106 und der Schirmelektrode 301 befindet sich die Trenneinheit 302, die dafür sorgt, dass beide Elektroden 106, 301 zeitgleich mit dem selben Signal beaufschlagt werden. Insbesondere wenn das Potenzial exakt gleich ist wird eine optimale Schirmwirkung erreicht. Des Weiteren sorgt die Trenneinheit 302 für eine Entkopplung zwischen der Messelektrode 106 und der Schirmelektrode 301. Eine Änderung am Ausgang der Trenneinheit 302 hat keinen Einfluss auf derer Eingang. Dies ist in diesem Zusammenhang mit Entkopplung gemeint.

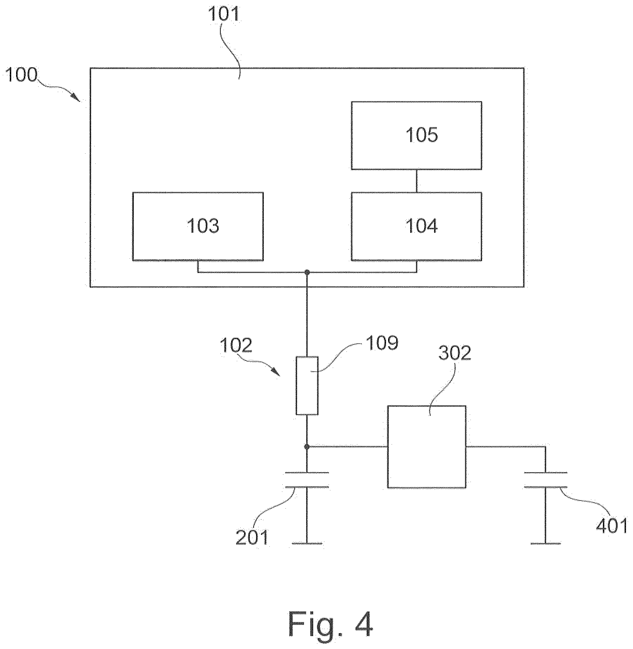

Die Amplitude und die Frequenz der Serienresonanzstelle wird folglicherweise nur durch die diskrete Induktivität 109 und die Messkapazität 201 bestimmt, nicht jedoch durch die Schirmkapazität 401 (vgl. Fig. 4). Die Schirmkapazität 401 wird durch die Schirmelektrode 301, die Isolierung 107 sowie die Bezugselektrode 108 gebildet und trägt nicht zum Resonanzverhalten bei.

Fig. 4 zeigt den Impedanzgrenzschalter 100 der Fig. 3, wobei die Messsonde 102 als Ersatzschaltbild dargestellt ist. Wesentliche Elemente der Messsonde sind die Messkapazität 201, die Trenneinheit 302 und die Schirmkapazität 401.

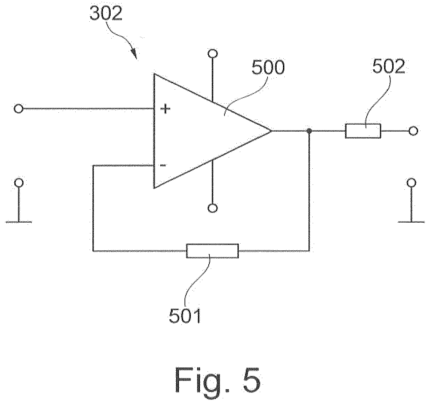

Fig. 5 zeigt eine Schaltungsanordnung einer Trenneinheit 302 gemäß einem Ausführungsbeispiel der Erfindung. Die Trenneinheit ist in Form eines Spannungsfolgers 500 in einer einfachen Ausführungsform ausgeführt. Prinzipiell ist ein Spannungsfolger eine Verstärkerschaltung mit einer Verstärkung von 1. Der Spannungsfolger 500 übernimmt an dieser Stelle die Aufgabe der Ansteuerung der Schirmelektrode 301 und sorgt dafür, dass eine Entkopplung zwischen der Messkapazität 201 und der Schinnkapazität 401 erreicht wird. Vorteilhafterweise wird die resonante Impedanzmessung in einem Frequenzbereich zwischen 100 MHz und 300 MHz durchgeführt. Somit muss auch die Verstärkerschaltung in diesem Bereich zuverlässig und sicher arbeiten.

In Fig. 6 ist das Impedanzverhalten des Impedanzgrenzschalters beispielhaft für das Medium Ketchup dargestellt. Die Simulationskurve 600 beschreibt das Resonanzverhalten einer sauberen Messsonde 102. Das Verhalten einer mit Ketchup verschmutzten Messsonde wird durch die Kurve 601 charakterisiert. Ist die Messsonde komplett mit Ketchup bedeckt, ergibt sich das Resonanzverhalten der Kurve 602. Die Schaltbefehle (leer, voll) werden von der Auswerteeinheit 105 (vgl. beispielsweise Fig. 1) erzeugt, wobei ausschließlich die Minima der Resonanzkurve für die Auswertung relevant sind. Diese werden bezüglich ihrer Frequenzänderung 603 und Amplitudenänderung 604 ausgewertet.

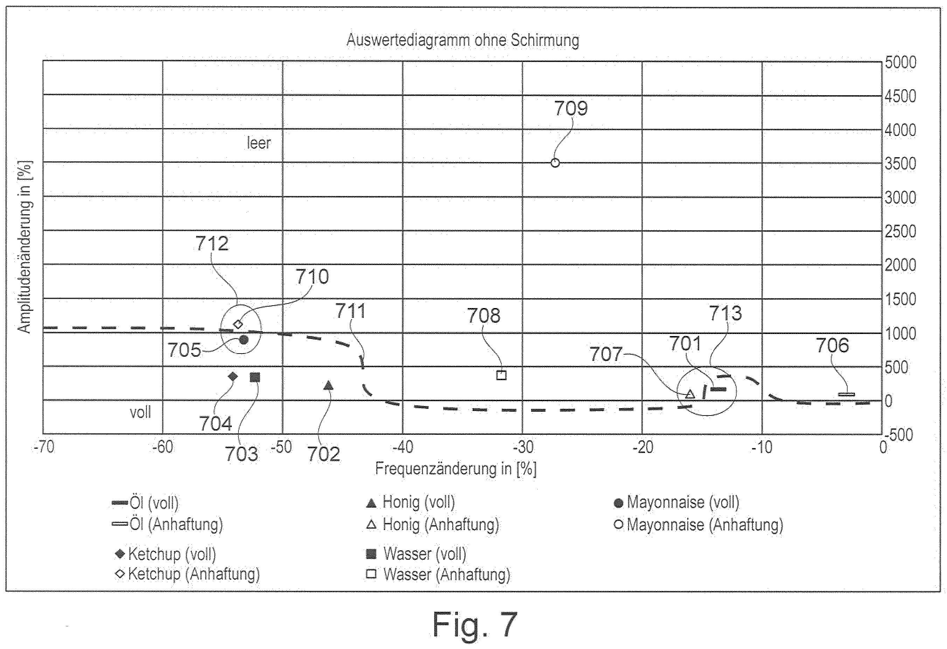

Fig. 7 zeigt ein Auswertediagramm des Impedanzgrenzschalters der Fig. 1. Dieses Diagramm beschreibt die Amplitudenänderung 604 als Funktion der Frequenzänderung 603 für unterschiedlichste Bedeckungszustände von verschiedenen Medien (vgl. Fig. 6). Die Symbole 701, 702, 703, 704 und 705 sind Minima von Vollzuständen unterschiedlicher Medien. Die Symbole 706, 707, 708, 709 und 710 sind Minima verschiedener Anhaftungsmedien. In diesem Diagramm befindet sich zudem eine Entscheidungsschwelle 711. Befindet sich ein Minimum unterhalb der Entscheidungsschwelle 711, so gibt die Auswerteeinheit 105 den Zustand "voll" aus. Befindet sich jedoch ein Minimum oberhalb dieser Entscheidungsschwelle, so wird der Zustand "leer" ausgegeben. Diese Grafik soll verdeutlichen, dass es kritische Entscheidungsbereiche (712, 713) gibt und dadurch eine sichere und zuverlässige Grenzstanddetektion nicht immer möglich ist. Nur durch einen Abgleichvorgang auf das zu messende Medium kann zuverlässig gemessen werden.

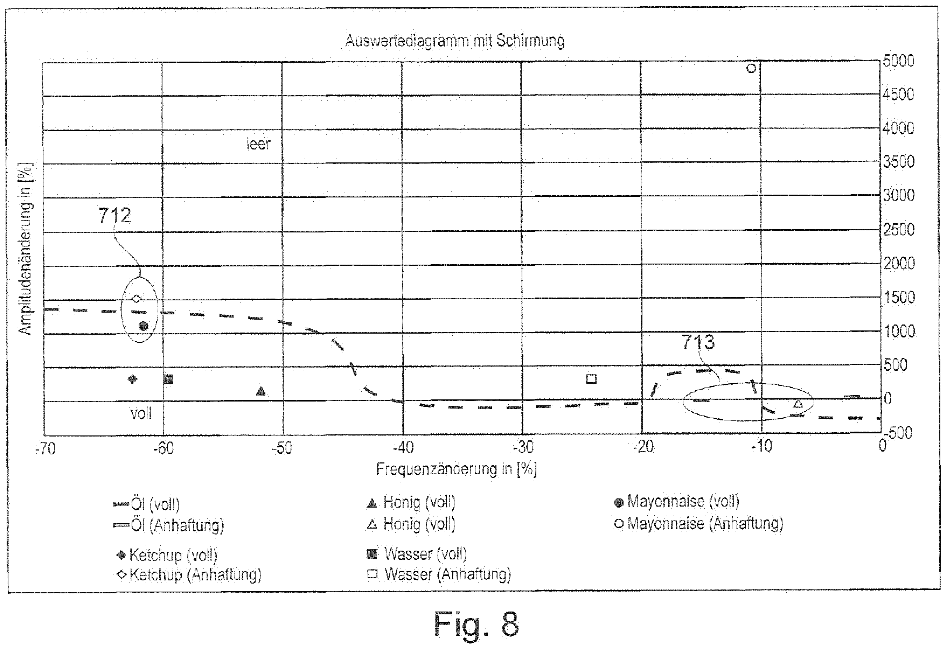

Fig. 8 zeigt ein Auswertediagramm für einen Impedanzgrenzschalter mit zusätzlicher Schirmelektrode. Auch in diesem Diagramm sind die Minima unterschiedlicher Bedeckungszustände verschiedener Medien aufgeführt. Aufgrund der Schirmwirkung sind die beiden kritischen Bereiche 712 und 713 jedoch besser aufgelöst. In anderen Worten, die Amplitudenänderungen und Frequenzänderungen der Resonanzpunkte bei unterschiedlichen Medien befinden sich weiter voneinander entfernt. Vorteilhafterweise kann auch ohne Einlernphase eine sichere und zuverlässige Grenzstanddetektion erfolgen.

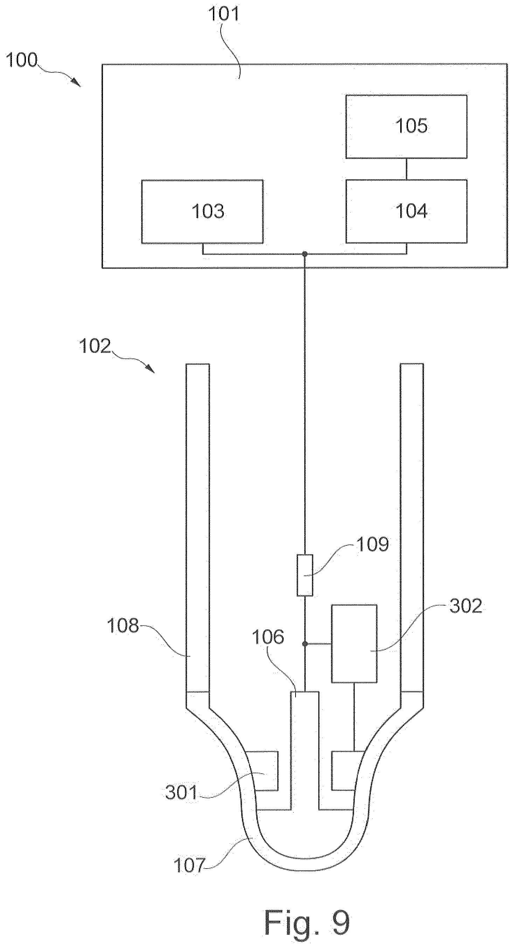

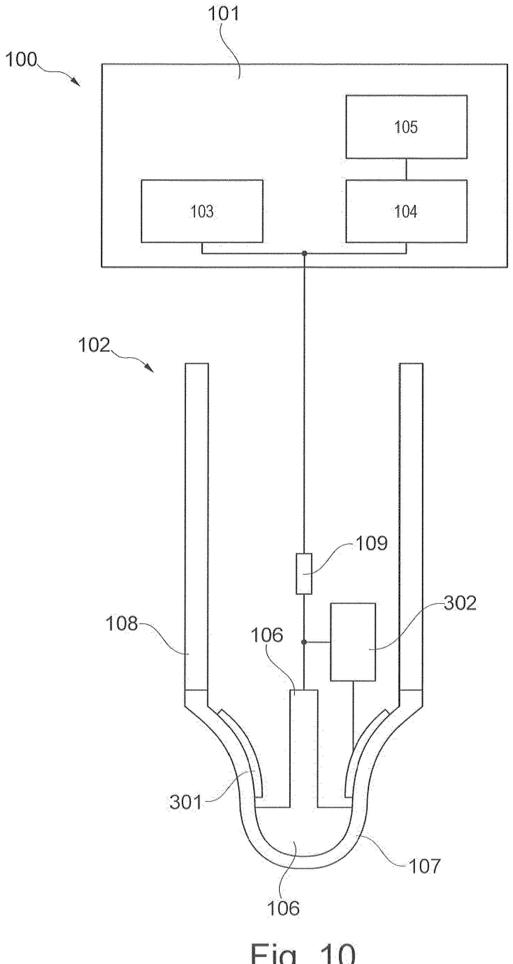

Neben der Elektrodenansteuerung ist deren Geometrie wichtig, um eine optimale Schirmwirkung zu erzielen. Dabei sollte der Raum zwischen der Messelektrode 106 und der Bezugselektrode 108 möglichst vollständig durch die Schirmelektrode 301 ausgefüllt sein. Die elektrische Feldverteilung wird dadurch tiefer ins Volumen gedrängt und der Einfluss von Anhaftungen auf die resonante Impedanzmessung verringert. In den Figuren 9 und 10 sind zwei weitere Ausführungsbeispiele mit unterschiedlich geformten Schirmelektroden 301 gezeigt.

In allen drei Ausführungsbeispielen (Fig. 3, Fig. 9, Fig. 10) sind die Schirmelektroden rotationssymmetrisch. In den Ausführungsbeispielen der Figuren 3 und 10 sind die Abstände zwischen der Schirmelektrode und der Messelektrode bzw. der Bezugselektrode deutlich kleiner als der Abstand zwischen Bezugselektrode 1 08 und Messelektrode 106. In anderen Worten schirmt die Schirmelektrode den Raum zwischen der Messelektrode und der Bezugselektrode zu einem hohen Prozentsatz ab. Im Ausführungsbeispiel der Fig. 9 ist die Schirmelektrode 301 zwar verhältnismäßig nahe an der Messelektrode 106 angeordnet. Jedoch ist der Abstand zwischen der Schirmelektrode und der Bezugselektrode 108 verhältnismäßig groß, sogar größer als die Schirmelektrode selbst. Trotzdem führt auch diese Ausführungsform dazu, dass das von der Messelektrode 106 erzeugte elektrische Feld möglichst tief in das Volumen des Mediums eindringt. Allerdings wird es wohl etwas flacher auf die Bezugselektrode 108 zulaufen.

In den Ausführungsbeispielen der Figuren 3 und 9 ist die Schirmelektrode voluminös, im Ausführungsbeispiel der Fig. 10 flächig ausgebildet.

In Abhängigkeit der Geometrie der Schirmelektrode ändert sich die Schirmkapazität. Vorteilhafterweise sollte die Schirmkapazität möglichst klein sein, um die kapazitive Last am Ausgang der Trenneinheit möglichst gering zu halten. Die kleinste Schirmkapazität wird durch die Elektrodengeometrie 301 in Figur 9 erzielt. Ein dominierender Parameter ist in diesem Zusammenhang der Abstand der Schirmelektrode zur Bezugselektrode. Je größer dieser Abstand gewählt wird, desto geringer ist die Schirmkapazität und desto weniger wird die Trenneinheit kapazitiv belastet. Die primäre Aufgabe der Trenneinheit liegt darin, das Eingangssignal amplitudengleich und phasengleich an den Ausgang weiterzuleiten, wobei der Ausgang vom Eingang entkoppelt ist. Die Phasengleichheit wird durch eine höhere kapazitive Last verschlechtert und demzufolge auch die Schirmwirkung. Trotzdem sollte der Abstand zwischen Schirmelektrode und Bezugselektrode nicht zu groß gewählt werden, da ansonsten die elektrischen Feldanteile zu flach auf die Bezugselektrode 108 zulaufen. Dadurch verschlechtert sich wiederum die Schirmwirkung.

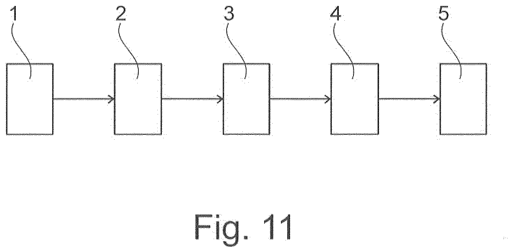

Fig. 11 zeigt ein Flussdiagramm eines Verfahrens gemäß einem Ausführungsbeispiel der Erfindung. In Schritt 1 wird ein Anregungssignal erzeugt, dessen Frequenz durchgefahren wird. Dieses Anregungssignal wird in Schritt 2 einem Schwingkreis zugeführt. Da die Schirmelektrode von der Messelektrode entkoppelt ist, wird der entsprechende Schwingkreis in Schritt 3 lediglich durch die Messkapazität und eine daran angeschlossene Induktivität, sowie, falls vorhanden, das Medium, das an der Messsonde anhaftet bzw. in welches die Messsonde eintaucht, ausgebildet. Man könnte auch sagen, dass der Schwingkreis durch das Medium bzw. die Anhaftung verstimmt wird, sodass sich Lage und Amplitude des Resonanzpunktes verschieben. In Schritt 4 wird dann die Amplitude und die Frequenz der Schwingung des Schwingkreises im Resonanzpunkt bestimmt und in Schritt 5 wird der Unterschied dieser beiden Größen im Vergleich zu einer Leermessung (Messsonde weist keine Anhaftung auf und taucht nicht in das Medium ein) bestimmt. Hieraus kann dann unter Zuhilfenahme einer Entscheidungsschwelle, wie sie in der Fig. 8 zu sehen ist, bestimmt werden, ob ein Grenzstand erreicht ist oder nicht.

Ergänzend sei daraufhingewiesen, dass "umfassend" und "aufweisend" keine anderen Elemente oder Schritte ausschließt und die unbestimmten Artikel "eine" oder "ein" keine Vielzahl ausschließen. Ferner sei darauf hingewiesen, dass Merkmale oder Schritte, die mit Verweis auf eines der obigen Ausführungsbeispiele beschrieben worden sind, auch in Kombination mit anderen Merkmalen oder Schritten anderer oben beschriebener Ausführungsbeispiele verwendet werden können. Bezugszeichen in den Ansprüchen sind nicht als Einschränkungen anzusehen.

## Patentansprüche

1. Impedanzgrenzschalter (100) zum Erfassen eines Grenzstandes eines Mediums, aufweisend:
eine Elektronikeinheit (101) zum Erzeugen eines Anregungssignals;
eine Messelektrode (106) und eine daran angeschlossene Induktivität (109), wobei das Anregungssignal an die Induktivität anlegbar ist, so dass sich ein Schwingkreis mit einem Schwingkreissignal in der Leitung zwischen der Induktivität und der Messelektrode ausbildet;
eine Bezugselektrode (108), welche beabstandet zur Messelektrode angeordnet ist, an welche ein Bezugspotenzial anlegbar ist und welche zusammen mit der Messelektrode eine Messkapazität bereitstellt;
eine Schirmelektrode (301), die zwischen der Messelektrode und der Bezugselektrode beabstandet von diesen angeordnet ist und eine Schirmkapazität ausbildet;
eine Trenneinheit (302), welche zwischen die Messelektrode und die Schirmelektrode geschaltet ist zum Übertragen des Schwingkreissignals, das zwischen der Induktivität und der Messelektrode auftritt, an die Schirmelektrode;
wobei die Trenneinheit zum Entkoppeln der Messkapazität von der Schirmkapazität ausgeführt ist, so dass ein Schwingkreis von der Messkapazität und der daran angeschlossenen Induktivität ausbildbar ist, der jedoch unabhängig von der Schirmkapazität ist.

2. Impedanzgrenzschalter (100) nach Anspruch 1,
wobei die Trenneinheit (302) ausgeführt ist, dafür zu sorgen, dass das Schwingkreissignal mit derselben Amplitude und Phase an die Messelektrode und die Schirmelektrode anlegbar ist.

3. Impedanzgrenzschalter (100) nach einem der vorhergehenden Ansprüche,
aufweisend eine stiftförmige Messsonde, in welcher die Messelektrode (106), die Schirmelektrode (301), die Bezugselektrode (108) und die Trenneinheit (302) angeordnet sind.

4. Impedanzgrenzschalter (100) nach Anspruch 3,
wobei der Kopfbereich der Messsonde eine Isolationsumhüllung (107) aufweist, welche die Messelektrode (106) und die Schirmelektrode (301) vom Medium isoliert.

5. Impedanzgrenzschalter (100) nach Anspruch 4,
wobei die Schirmelektrode (301) an der Innenwandung der Isolationsumhüllung (107) anliegt.

6. Impedanzgrenzschalter (100) nach einem der vorhergehenden Ansprüche, wobei die Schirmelektrode (301) ringförmig ausgebildet ist.

7. Impedanzgrenzschalter (100) nach einem der vorhergehenden Ansprüche,
wobei die Messelektrode (106), die Schirmelektrode (301) und die Bezugselektrode (108) konzentrisch angeordnet sind.

8. Impedanzgrenzschalter (100) nach einem der vorhergehenden Ansprüche,
wobei die Trenneinheit (302) eine Verstärkerschaltung (500) mit einer Verstärkung von eins aufweist.

9. Impedanzgrenzschalter (100) nach einem der vorhergehenden Ansprüche,
aufweisend eine flächige Messsonde, in welcher die Messelektrode (106), die Schirmelektrode (301) und die Bezugselektrode (108) konzentrisch in einer Ebene angeordnet sind.

10. Verwendung eines Impedanzgrenzschalters (100) nach einem der vorhergehenden Ansprüche zum Erfassen eines Grenzstandes eines Mediums.

11. Verfahren zum Erfassen eines Grenzstandes eines Mediums mit einem Impedanzgrenzschalter (100), aufweisend die Schritte:
Erzeugen eines Anregungssignals;
Anlegen des Anregungssignals an eine Induktivität (109), an welche eine Messelektrode (106) angeschlossen ist;
Ausbilden eines Schwingkreises, in welchem ein Schwingkreissignal in der Leitung zwischen der Induktivität und der Messelektrode fließt, durch die Messkapazität, die von der Messelektrode und eine Bezugselektrode gebildet wird, und die Induktivität;
Anlegen des Schwingkreissignals an eine Schirmelektrode (301), die zwischen der Messelektrode und der Bezugselektrode beabstandet von diesen angeordnet ist und eine Schirmkapazität ausbildet;
Entkoppeln der Messkapazität von der Schirmkapazität, so dass der Schwingkreis nur von der Messkapazität und der Induktivität ausgebildet wird, nicht jedoch auch von der Schirmkapazität;
Bestimmen der Amplitude und Frequenz der Schwingung des Schwingkreises im Resonanzpunkt zur Detektion eines Grenzstandes.

## Claims

1. Impedance limit switch (100) for detecting a limit level of a medium, comprising:
an electronics unit (101) for generating an excitation signal;
a measuring electrode (106) and an inductor (109) connected thereto, wherein the excitation signal can be applied to the inductor so that an oscillating circuit with an oscillating circuit signal is formed in the line between the inductor and the measuring electrode;
a reference electrode (108), which is arranged at a distance from the measuring electrode, to which a reference potential can be applied and which, together with the measuring electrode, provides a measuring capacitance;
a shield electrode (301) disposed between and spaced from the measurement electrode and the reference electrode and forming a shield capacitance;
an isolation unit (302) connected between the measurement electrode and the shield electrode for transmitting the resonant circuit signal occurring between the inductor and the measurement electrode to the shield electrode;
wherein the separating unit is configured to decouple the measuring capacitance from the screen capacitance, so that an oscillating circuit can be formed by the measuring capacitance and the inductance connected thereto, but which is independent of the screen capacitance.

2. Impedance limit switch (100) according to claim 1,
wherein the isolation unit (302) is adapted to ensure that the oscillating circuit signal can be applied with the same amplitude and phase to the measurement electrode and the shield electrode.

3. Impedance limit switch (100) according to any one of the preceding claims, comprising a pin-shaped measuring probe in which the measuring electrode (106), the screen electrode (301), the reference electrode (108) and the separating unit (302) are arranged.

4. Impedance limit switch (100) according to claim 3,
wherein the head portion of the measuring probe has an insulation sheath (107) which insulates the measuring electrode (106) and the shield electrode (301) from the medium.

5. Impedance limit switch (100) according to claim 4,
wherein the shield electrode (301) abuts the inner wall of the insulation sheath (107).

6. Impedance limit switch (100) according to any one of the preceding claims,
wherein the shield electrode (301) is annular in shape.

7. Impedance limit switch (100) according to any one of the preceding claims,
wherein the measurement electrode (106), the shield electrode (301), and the reference electrode (108) are concentrically arranged.

8. Impedance limit switch (100) according to any one of the preceding claims,
wherein the isolation unit (302) comprises an amplifier circuit (500) having a gain of one.

9. Impedance limit switch (100) according to any one of the preceding claims,
comprising a flat measuring probe in which the measuring electrode (106), the screen electrode (301) and the reference electrode (108) are arranged concentrically in one plane.

10. Use of an impedance limit switch (100) according to any one of the preceding claims for detecting a limit level of a medium.

11. Method of detecting a limit level of a medium with an impedance limit switch (100), comprising the steps of:
Generating an excitation signal;
Applying the excitation signal to an inductor (109) to which a measuring electrode (106) is connected;
Forming an oscillating circuit in which an oscillating circuit signal flows in the line between the inductance and the measuring electrode, by the measuring capacitance formed by the measuring electrode and a reference electrode, and the inductance;
Applying the oscillating circuit signal to a shield electrode (301) disposed between and spaced from the measurement electrode and the reference electrode to form a shield capacitance;
Decoupling of the measuring capacitance from the shield capacitance, so that the oscillating circuit is formed only by the measuring capacitance and the inductance, but not also by the shield capacitance;
Determine the amplitude and frequency of the oscillation of the resonant circuit at the resonance point to detect a limit level.

## Revendications

1. Interrupteur limiteur à impédance (100) pour détecter un niveau limite d'un milieu, présentant :
une unité électronique (101) pour générer un signal d'excitation ;
une électrode de mesure (106) et une inductance (109) connectée à celle-ci, le signal d'excitation pouvant être appliqué à l'inductance de telle sorte qu'un circuit oscillant avec un signal de circuit oscillant soit formé dans la ligne entre l'inductance et l'électrode de mesure ;
une électrode de référence (108) qui est disposée à une certaine distance de l'électrode de mesure, à laquelle un potentiel de référence peut être appliqué et qui,
conjointement avec l'électrode de mesure, fournit une capacité de mesure ;
une électrode de blindage (301) qui est disposée entre l'électrode de mesure et l'électrode de référence à une certaine distance de celles-ci et qui forme une capacité de blindage ;
une unité de séparation (302) qui est branchée entre l'électrode de mesure et l'électrode de blindage pour transmettre le signal de circuit oscillant apparaissant entre l'inductance et l'électrode de mesure à l'électrode de blindage ;
dans lequel l'unité de séparation est conçue pour découpler la capacité de mesure de la capacité de blindage de telle sorte qu'un circuit oscillant peut être formé par la capacité de mesure et l'inductance connectée à celle-ci, lequel est cependant indépendant de la capacité de blindage.

2. Interrupteur limiteur à impédance (100) selon la revendication 1,
dans lequel l'unité de séparation (302) est conçue pour faire en sorte que le signal de circuit oscillant puisse être appliqué avec la même amplitude et la même phase à l'électrode de mesure et à l'électrode de blindage.

3. Interrupteur limiteur à impédance (100) selon l'une des revendications précédentes,
présentant une sonde de mesure en forme de tige dans laquelle l'électrode de mesure (106), l'électrode de blindage (301), l'électrode de référence (108) et l'unité de séparation (302) sont disposées.

4. Interrupteur limiteur à impédance (100) selon la revendication 3,
dans lequel la zone de tête de la sonde de mesure présente une enveloppe isolante (107) qui isole l'électrode de mesure (106) et l'électrode de blindage (301) du milieu.

5. Interrupteur limiteur à impédance (100) selon la revendication 4,
dans lequel l'électrode de blindage (301) est en contact avec la paroi intérieure de l'enveloppe isolante (107).

6. Interrupteur limiteur à impédance (100) selon l'une des revendications précédentes,
dans lequel l'électrode de blindage (301) est réalisée en forme d'anneau.

7. Interrupteur limiteur à impédance (100) selon l'une des revendications précédentes,
dans lequel l'électrode de mesure (106), l'électrode de blindage (301) et l'électrode de référence (108) sont disposées concentriquement.

8. Interrupteur limiteur à impédance (100) selon l'une des revendications précédentes,
dans lequel l'unité de séparation (302) présente un circuit amplificateur (500) ayant un gain de un.

9. Interrupteur limiteur à impédance (100) selon l'une des revendications précédentes,
présentant une sonde de mesure plane dans laquelle l'électrode de mesure (106), l'électrode de blindage (301) et l'électrode de référence (108) sont disposées concentriquement dans un plan.

10. Utilisation d'un interrupteur limiteur à impédance (100) selon l'une des revendications précédentes pour détecter un niveau limite d'un milieu.

11. Procédé de détection d'un niveau limite d'un milieu avec un interrupteur limiteur à impédance (100), présentant les étapes consistant à :
générer un signal d'excitation ;
appliquer le signal d'excitation à une inductance (109) à laquelle une électrode de détection (106) est connectée ;
former un circuit oscillant, dans lequel un signal de circuit oscillant circule dans la ligne entre l'inductance et l'électrode de mesure, par la capacité de mesure, qui est formée par l'électrode de mesure et une électrode de référence, et l'inductance ;
appliquer le signal de circuit oscillant à une électrode de blindage (301) qui est disposée entre l'électrode de mesure et l'électrode de référence à une certaine distance de celles-ci et qui forme une capacité de blindage ;
découpler la capacité de mesure de la capacité de blindage de telle sorte que le circuit oscillant soit formé uniquement par la capacité de mesure et l'inductance, et non également par la capacité de blindage ;
déterminer l'amplitude et la fréquence de l'oscillation du circuit oscillant au point de résonance pour détecter un niveau limite.
